(19)

Europäisches Patentamt

European Patent Office

Office européen des brevets

(11) **EP 4 787 708 A1**

(12) **EUROPEAN PATENT APPLICATION**

(43) Date of publication:
05.08.2026 Bulletin 2026/32

(21) Application number: 26155121.2

(22) Date of filing: 29.01.2026

(51) International Patent Classification (IPC):
*H03F 3/195* (2006.01)   *H03F 3/24* (2006.01)
*H03F 3/45* (2006.01)   *H03F 3/62* (2006.01)
*H03F 3/72* (2006.01)   *H04B 1/44* (2006.01)

(52) Cooperative Patent Classification (CPC):
**H03F 3/245; H03F 3/195; H03F 3/45183;
H03F 3/62; H03F 3/72; H04B 1/44;** H03F 2200/451;
H03F 2203/45318

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 31.01.2025  US 202563752469 P

(71) Applicant: **Space Exploration Technologies Corp.**
**Hawthorne, California 90250 (US)**

(72) Inventors:
• **SOTNICK, Elliot**
 **Hawthorne, California, 90250 (US)**
• **AGAH, Amir**
 **Hawthorne, California, 90250 (US)**

(74) Representative: **Mewburn Ellis LLP**
**Aurora Building**
**Counterslip**
**Bristol BS1 6BX (GB)**

(54) **BIDIRECTIONAL DIFFERENTIAL AMPLIFIER**

(57)    A FEM includes a transmit amplifier (405) comprising a first transistor and a second transistor coupled between first and second differential nodes, a receive amplifier (415) comprising a third transistor and a fourth transistor coupled between the first and second differential nodes. The transmit amplifier (405) includes pseudo-differential input capacitively coupled with the first differential node and produces a differential output at the second differential node. The receive amplifier (415) includes a differential input capacitively coupled with the second differential node and produces a differential output cross-coupled with the first differential node. Common terminals for the receive amplifier (415) are selectively coupled with ground in receive mode and voltage supply in transmit mode. The receive amplifier (415) supplies a neutralizing feedback to the first differential node in transmit mode, and the transmit amplifier (405) supplies a neutralizing feedback to the second differential node in receive mode.

FIG. 4A

EP 4 787 708 A1

**Description**

CROSS-REFERENCE TO RELATED APPLICATIONS

The present application claims the benefit of, and priority to, U.S. Provisional Patent Application No. 63/752,469, filed January 31, 2025, entitled "BIDIRECTIONAL DIFFERENTIAL AMPLIFIER", the contents of which are hereby incorporated by reference in their entirety.

TECHNICAL FIELD

The present disclosure pertains to phased array antennas for satellite communication systems and, more particularly, a bidirectional differential amplifier for transmitting and receiving radio frequency (RF) signals.

BACKGROUND

An antenna (such as a dipole antenna) typically generates radiation in a pattern that has a preferred direction. For example, the generated radiation pattern is stronger in some directions, i.e., the main lobes, and weaker in other directions, i.e., the side lobes. Likewise, when receiving electromagnetic signals, the antenna has the same preferred direction. Signal quality (e.g., signal to noise ratio or SNR), whether in transmitting or receiving scenarios, can be improved by aligning the preferred direction of the antenna with a direction of the target or source of the signal. A phased array antenna can be composed of an array of antenna elements, each having an electronically controlled phase and amplitude. An advantage of a phased array antenna is its ability to transmit and/or receive signals in a preferred direction (e.g., the antenna's beamforming ability) by adjusting each antenna element's phase delay and amplitude to "direct" the resulting transmitted or received wavefront.

Phased array antennas and, more specifically for transmitting, each antenna element in the array, must be fed one or more radio frequency (RF) signals, or beams, to be emitted; each beam being derived from a common digital signal. Similarly, when receiving, the beams received at each antenna element in the array must be routed and combined to reconstruct one or more received digital signals. As phased arrays increase in number of elements, the distribution and combination network for the RF signals tends to degrade the RF signals as they propagate further and through more components, either to an antenna element for transmission or to a beamformer for processing.

It would be advantageous to configure phased array antennas with more antenna elements, improved phase and/or gain stability, while reducing size of the corresponding components, e.g., integrated circuits, chips, chip packages, circuit boards, etc. Accordingly, embodiments of the present disclosure are directed to these and other improvements in phased array antennas or portions thereof.

SUMMARY

In some examples, systems and techniques are described for providing bidirectional amplifiers.

In some aspects, the techniques described herein relate to a bidirectional differential amplifier, including: a first differential node configured as a differential transmit input node for a transmit mode and a differential receive output node for a receive mode; a second differential node configured as a differential transmit output node for the transmit mode and a differential receive input node for the receive mode; a transmit amplifier including a first transistor and a second transistor coupled between the first differential node and the second differential node and configured to produce a differential output transmit signal at the second differential node, the first transistor and the second transistor together including: a transmit pseudo-differential input coupled with a first bias voltage source and capacitively coupled with the first differential node; and a transmit differential output coupled with the second differential node; and a receive amplifier including a third transistor and a fourth transistor coupled between the first differential node and the second differential node and configured to produce a differential output receive signal at the first differential node, the third transistor and the fourth transistor including: a receive differential input coupled with a second bias voltage source and capacitively coupled with the second differential node; a receive differential output cross-coupled with the first differential node; and common terminals configured to be selectively coupled with ground when in the receive mode, and with a voltage supply when in the transmit mode; wherein, when in the transmit mode, the third transistor and the fourth transistor are configured to supply a neutralizing transmit feedback to the first differential node that is opposite in phase relative to the differential output transmit signal; and wherein, when in the receive mode, the first transistor and the second transistor are configured to supply a neutralizing receive feedback to the second differential node that is opposite in phase relative to the differential output receive signal.

In some aspects, the techniques described herein relate to a front end module for a phased array antenna, the front end module including: a first radio frequency (RF) serial port configured to receive an RF transmit signal for transmission over a channel when in a transmit mode and an RF receive signal received over the channel when in a receive mode; an RF interchange coupled in series with the first RF serial port and configured to: distribute the RF transmit signal to one or more antenna paths corresponding to one or more antenna elements when in the transmit mode; and combine the RF receive signal from the one or more antenna paths when in the receive mode; a second RF serial port configured to feed through the RF transmit signal to a second front end module when in the transmit mode and feed through the RF receive signal from the second front end module when in the receive mode; and a bidirectional amplifier coupled between the first RF serial port and the second RF serial port.

This summary is not intended to identify key or essential features of the claimed subject matter, nor is it intended to be used in isolation to determine the scope of the claimed subject matter. The subject matter should be understood by reference to appropriate portions of the entire specification of this patent, any or all drawings, and each claim.

The foregoing, together with other features and aspects, will become more apparent upon referring to the following specification, claims, and accompanying drawings.

DESCRIPTION OF THE DRAWINGS

The foregoing aspects and many of the attendant advantages of this invention will become more readily appreciated as the same become better understood by reference to the following detailed description, when taken in conjunction with the accompanying drawings, wherein:

FIG. 1 is a block diagram of a portion of an example phased array antenna system in accordance with some examples of the present disclosure;

FIG. 2 is a top view of an example antenna lattice in accordance with some examples of the present disclosure;

FIG. 3A is a functional block diagram of an example embodiment of a front end module in accordance with some examples of the present disclosure;

FIG. 3B is a functional block diagram of another example embodiment of a front end module in accordance with some examples of the present disclosure;

FIG. 3C is a functional block diagram of another example embodiment of a front end module in accordance with some examples of the present disclosure;

FIG. 3D is a functional block diagram of yet another example embodiment of a front end module in accordance with some examples of the present disclosure;

FIG. 4A is a schematic diagram of an example bidirectional differential amplifier in accordance with some examples of the present disclosure;

FIG. 4B is a schematic diagram of the bidirectional differential amplifier shown in FIG. 4A when operating in a transmit mode; and

FIG. 4C is a schematic diagram of the bidirectional differential amplifier shown in FIG. 4A when operating in a receive mode.

DETAILED DESCRIPTION

Embodiments of the disclosed apparatuses and methods relate to phased array antenna systems and, in particular, a bidirectional differential amplifier. The disclosed bidirectional differential amplifier includes a transistor network for amplification and neutralization that is shared between the transmit (Tx) and receive (Rx) operating modes. Examples of the devices, systems, and/or methods of various embodiments are provided below. An embodiment of the devices, systems, and/or methods can include any one or more, and any combination of, the examples described below.

References in the specification to "one embodiment," "an embodiment," "an illustrative embodiment," "an example," etc., indicate that the embodiment described may include a particular feature, structure, or characteristic, but every embodiment may or may not necessarily include that particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. Additionally, it should be appreciated that items included in a list in the form of "at least one A, B, and C" means at least one of (A), at least one of (B), and at least one of (C). Conversely, items listed in the form of "at least one of A, B, or C" can mean (A); (B); (C); (A and B); (B and C); (A and C); or (A, B, and C).

Language such as "top surface", "bottom surface", "vertical", "horizontal", and "lateral" in the present disclosure is meant to provide orientation for the reader with reference to the drawings and is not intended to be the required orientation of the components or to impart orientation limitations into the claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, it may not be included or may be combined with other features.

In a phased array antenna, each antenna element is driven by a dedicated radio frequency (RF) transmitter, or transmit circuit, and/or connected to a dedicated RF receiver, or receive circuit. The "RF transmitter" and "RF receiver" are generally used herein to refer to the end-to-end collection of components operating between a digital system, i.e., a modem, and an antenna, or antenna element, for the transmit path and the receive path, respectively, including, for example and without limitation, digital baseband beamforming components, RF waveform generators/receivers, and analog beamforming components. In some implementations, all such components are packaged together in a beamformer chip. In the disclosed phased array antenna systems, digital baseband beamforming components and RF waveform generators/receivers are packaged together for one or more given antenna elements in a digital beamformer (DBF). The DBF communicates with a modem, for example, to exchange digital data for transmitting and receiving. When transmitting, the DBF's digital baseband beamforming components construct one or more phase encoded beams to carry the digital data. The DBF's RF waveform generator components convert the one or more phase encoded beams from digital to analog, up-convert to RF, and amplify for transmission by the array of antenna elements. When receiving, the DBF's RF waveform receiver components amplify beams received by the array of antenna elements, down-convert to baseband, and digitize analog signals (e.g., convert from analog to digital). The digital beams are then recombined, phase decoded, and digitally filtered before communicating the received digital data to the modem.

In the disclosed phased array antenna systems, the DBF is paired with at least one "front end module" (FEM), generally incorporating analog beamforming components. The FEM could be a distinct FEM device, or chip, driving one or more antenna elements; or the FEM could be a component grouping within a DBF device, or chip, in which the RF transmitter and/or RF receiver are packaged. A DBF package, or a DBF and FEM pair, may include numerous RF transmitters and/or RF receivers for corresponding antenna elements. Alternatively, each DBF and FEM could be packaged independently for a single antenna element.

When transmitting, each antenna element in the phased array transmits an RF signal with a respective desired phase and amplitude to emit one or more desired directional beams. In some cases, a desired phase and amplitude are achieved by applying a particular phase shift and/or gain at the FEM for each antenna element. In certain embodiments, the particular phase shift and/or gain to be applied can be based on an instruction from the DBF or other controller. The phase shifts and gains can be selected for each antenna element to produce constructive interference in a transmit direction (e.g., a beam steering direction). One or more RF signals can be distributed to each FEM from a DBF. In phased array antennas having a large number of antenna elements, there may be numerous DBFs, each driving a network of FEMs, and each FEM driving one or more antenna elements. Accordingly, one or more baseband digital signals is distributed to each DBF, conditioned, and/or up converted to RF or IF, and then distributed to each FEM.

When receiving, the phased array is configured to receive from a particular beam steering direction. The FEM for each antenna element applies desired phase shifts and/or gains to produce constructive interference of signals received over the air from the particular beam steering direction (e.g., a receive direction). Each antenna element in the phased array receives the same over the air RF signal at a different position on the array, generally resulting in a different phase and amplitude of the received RF signals at different antenna elements depending on a transmission location of the over the air RF signal, the relative position of the transmitter and the receiving phased array, and the position of the antenna element in the antenna lattice of the phased array. The desired phase shift and/or gain associated with the particular beam steering direction can be applied at the respective FEMs for each antenna element. In certain embodiments, the particular phase shift and/or gain to be applied can be based on an instruction from a DBF or other controller. In certain embodiments, by carefully applying gain and/or phase shifts to the received signals from the antenna elements, the received signals from different antenna elements can interfere constructively for signals received from the beam steering direction. The phase shifted and/or gain adjusted received RF signals are then routed to the DBF for recombination and/or down-conversion to a baseband or IF signal. As described above, in phased array antennas having a large number of antenna elements, there may be numerous DBFs, each receiving RF signals from a network of FEMs, and each FEM receiving from one or more antenna elements. Accordingly, the received RF signal is routed through each FEM to a corresponding DBF.

Beams for transmission may be distributed serially by a DBF over a serial distribution channel to each FEM in a given FEM series, or "daisy chain." Each FEM distributes each beam to each of its corresponding antenna elements.

Similarly, beams received over the air are routed from each antenna element to its corresponding FEM, and then routed serially through each FEM in a given FEM series to its corresponding DBF. The transmit RF signal path and the receive RF signal path each can include one or more stages of amplification. Conventionally, the transmit RF signal path includes one or more power amplifiers in series between each DBF and each of its corresponding FEMs, and/or in series between each FEM and each of its corresponding antenna elements. Likewise, the conventional receive RF signal path includes one or more low noise amplifiers (LNAs) in series between each antenna element and its corresponding FEM, and/or in series between each FEM and its corresponding DBF. Accordingly, as the number of antenna elements in a given phased array antenna increases, so do the numbers of amplifiers.

The disclosed bidirectional differential amplifier includes a network of transistors for amplification and neutralization that is shared between the transmit RF signal path and the receive RF signal path, i.e., shared between the Tx mode and the Rx mode. The shared transistors enables reduction of components and space saving within certain integrated circuits and chips of up to 40% or greater. The disclosed bidirectional differential amplifier includes neutralization transistors for both Tx mode and Rx mode that results in lower input and output capacitances and greater stability, which enables increased bandwidth for the bidirectional differential amplifier and, in certain embodiments, multiple frequency band operation.

Conventionally, in metal oxide semiconductor field effect transistor (MOSFET) and/or bipolar junction transistor (BJT) implemented power amplifiers and low noise amplifiers, for example, the size of the amplifying transistors for power amplifiers is often different from the size of the transistors for low noise amplifiers. For either, the corresponding neutralization transistors are typically selected to introduce a properly tuned capacitive feedback (e.g., via their parasitic gate-to-source and/or gate-to-drain capacitances) to counter the parasitic capacitance of the amplifying transistors without destabilizing the circuit.

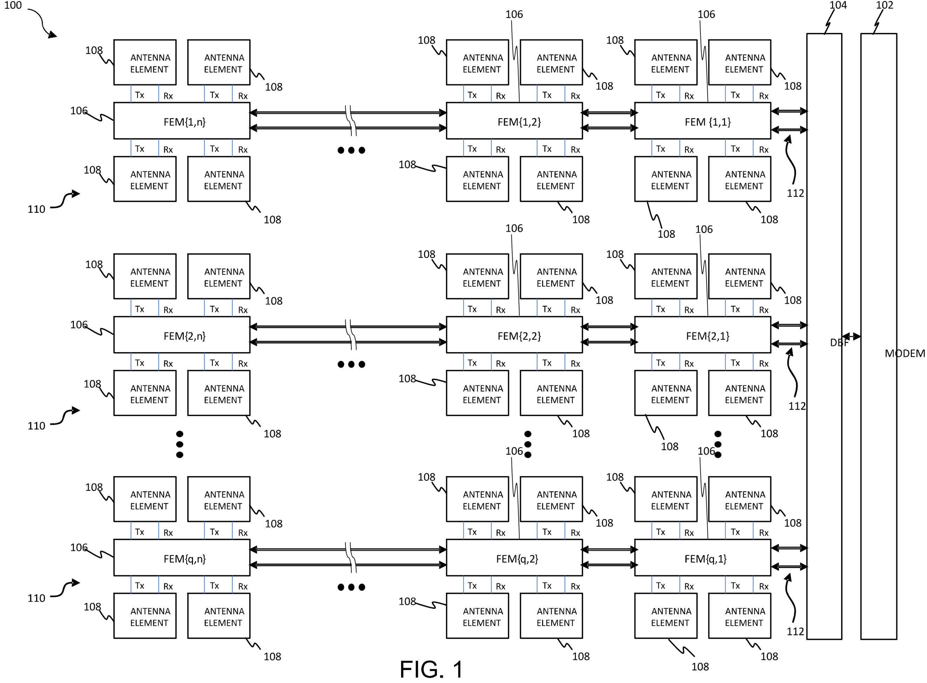

FIG. 1 is a block diagram of an example phased array antenna system 100 in accordance with some embodiments of the present disclosure. Phased array antenna system 100, also referred to as a node, communication device, device, and/or the like, is a component of a larger communications system. In some embodiments, phased array antenna system 100 is included in a wireless communications system, a wideband communications system, a satellite-based communications system, a terrestrial-based communications system, a non-geostationary (NGO) satellite communications system, a low Earth orbit (LEO) satellite communications system, and/or the like. For example, without limitation, phased array antenna system 100 can comprise a satellite, a user terminal associated with user device(s), a gateway, a repeater, or other device capable of receiving and transmitting signals with another device of a satellite communications system.

Phased array antenna system 100 includes a modem 102, a digital beamformer (DBF) chip (referred to herein as DBF 104), a plurality of FEMs 106, and a plurality of antenna elements 108. Modem 102 electrically couples to one or more DBFs, such as, for example, DBF 104. DBF 104 electrically couples with a number, q, of corresponding series, or "daisy chains," of the plurality of FEMs 106. Each of the q daisy chains of FEMs 106 is referred to herein as an FEM series 110. Each FEM series 110 electrically couples serially with a number, n, of FEMs 106. Each DBF chip electrically coupled with modem 102 is similarly configured and associated with respective series of FEMs 106. DBF 104 may also be referred to as a DBF chip, a transmit/receive (Tx/Rx) DBF chip, a Tx/Rx chip, a transceiver, a DBF transceiver, and/or the like.

Each FEM 106 of the q FEM series 110 electrically couples with a respective subset of the plurality of antenna elements 108, e.g., M antenna elements 108. A same subset of antenna elements can be used for transmit and receive signal paths within phased array antenna system 100. As an example, without limitation, DBF 104 supports q FEM series 110, each supporting up to 4 FEMs 106 (e.g., n=4) and up to 16 antenna elements (M=16) of the plurality of antenna elements 108. Alternatively, DBF 104 may support more or fewer antenna elements without departing from the scope of the present disclosure.

The phased array antenna system 100 includes a number, L, of DBFs 104. Each of the plurality of DBFs 104 may be electrically coupled to another in a daisy chain arrangement (not shown), i.e., the ith DBF of the plurality of DBFs 104 is electrically coupled with the (*i*th+1) DBF. For example, DBF 104 may be electrically coupled between modem 102 and a second DBF (not shown), and the second DBF may be electrically coupled between the first DBF and a third DBF, and so on.

DBF 104 includes an IC chip or IC chip package including a plurality of pins, in which at least a first subset of the plurality of pins is configured to communicate signals with its electrically coupled DBF chip(s) (and/or modem 102). A second subset of the plurality of pins of DBF 104 is configured to receive, for example, an LO signal (or reference clock signal) from a distribution network (not shown). The LO signal is generated by an LO (not shown). In certain embodiments, the LO is an integrated circuit (IC) chip. In some embodiments, the LO is included within an IC chip with one or more additional components, e.g., DBF 104. For example, LO signal can be distributed to or within DBF 104 to mixers within DBF 104 to facilitate performance of frequency up-conversion to radio frequency (RF) signals to be transmitted and/or frequency down-conversion of received RF signals. The LO may include, for example and without limitation, a transmit phase-locked loop (Tx PLL), a receive phase-locked loop (Rx PLL), a frequency multiplier, a multiplexer (MUX) for selecting between transmit and receiver, and/or a power amplifier (PA).

A third subset of the plurality of pins on the IC package of DBF 104 is configured to transmit RF signals and/or receive RF signals with FEMs 106 and antenna elements 108. DBF 104, for example, includes a plurality of RF input/output (RFIO) channels 112. Each FEM series 110 is electrically coupled with one or more RFIO channels 112. Each FEM series 110 includes one or more, or n, serially fed FEMs 106. For example, a first FEM series 110 includes a first FEM 106 (e.g., FEM {1,1}), a second FEM 106 (e.g., FEM {1,2}), and so on up to an nth FEM 106 (e.g., FEM {1,n}). Each FEM 106 illustrated in FIG. 1 is annotated with a {row, column} designation, where the "row" designation indicates to which FEM series 110 for DBF 104 a given FEM 106 belongs (e.g., 1 to q), and the "column" designation indicates where in that FEM series 110 the given FEM is positioned (e.g., 1 to n). For example, FEM {2, 1} is an FEM 106 in a second FEM series and a first FEM 106 in that FEM series 110. Likewise, FEM {q, n} is an FEM 106 in a qth FEM series and an nth FEM 106 in that FEM series 110.

RFIO channels 112, when transmitting, are configured to feed an RF signal to their respective FEM series 110. The RF signal is the result of frequency up-conversion performed within DBF 104 and is formed based on a transmit LO signal, i.e., the RF signal for transmission has a phase and frequency that is a function of the phase and frequency of the transmit LO signal. The RF signal is distributed to each FEM series 110 over an equal length signal path to minimize phase shift differences between signals arriving at the inputs of, for example, a first FEM series 110 and second FEM series 110. In some cases, phase shift differences between signals arriving at different FEM series 110 may result in phase errors in the RF signals provided to corresponding antenna elements 108 that emit the RF signals. Each FEM 106 may perform additional analog beamforming including, for example, phase shifting and/or amplification, before feeding each antenna element 108.

Referring again to the embodiment shown in FIG. 1, each of RFIO channels 112, when receiving, is configured to receive an RF signal from one of FEM series 110. The RF signal is received over the air at antenna elements 108 for each of the FEM series 110. Each FEM 106 may perform analog beamforming on the received RF signal, including, for example, phase shifting and/or amplification. In certain embodiments, each FEM 106 may also perform down-conversion to baseband or an IF. The RF (or IF or baseband) signals are then combined and propagated through the respective FEM series toward DBF 104 at RFIO channel 112. DBF 104, upon receipt of the RF signal, performs frequency down-conversion to a baseband or IF for further signal processing including, for example, analog to digital conversion.

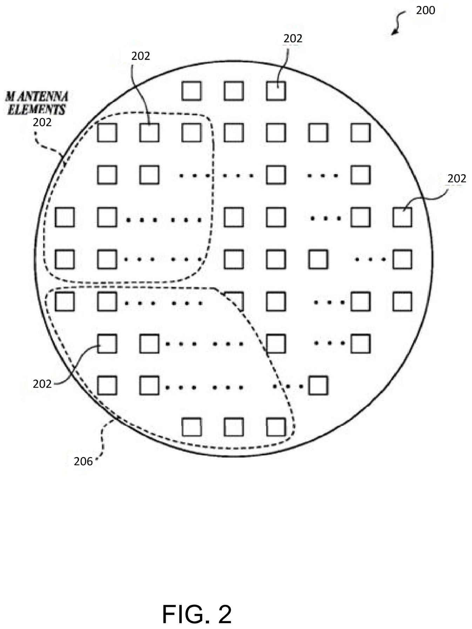

FIG. 2 is an example illustration of a top view of an antenna lattice 200 in accordance with some embodiments of the present disclosure. Antenna lattice 200 may be used, for example, in phased array antenna system 100 and, more specifically, for the plurality of antenna elements 108 shown in FIG. 1. Antenna lattice 200 includes a plurality of antenna elements 202 arranged in a particular pattern to define a particular antenna aperture. The antenna aperture is the area through which power is radiated by or to the plurality of antenna elements 202. Antenna lattice 200 defines a phased array antenna. A phased array antenna synthesizes a specified electric field (phase and amplitude) across an aperture.

Referring to FIGS. 1 and 2, a subset 206 of the plurality of antenna elements 202 shown in FIG. 2 can form the M antenna elements 108 corresponding to a particular DBF 104. The remaining subsets of antenna elements of the plurality of antenna elements 202 may be similarly associated with other DBFs.

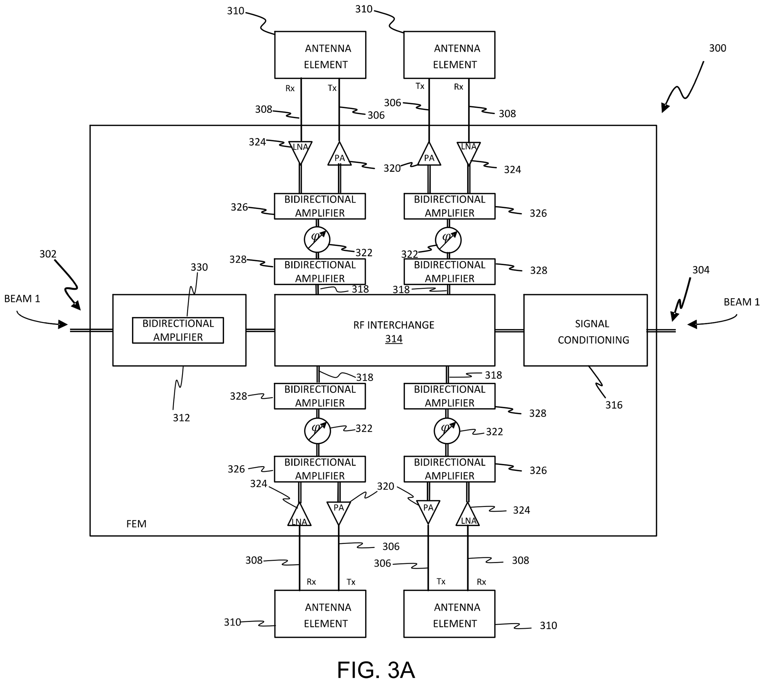

FIG. 3A is a functional block diagram of an example FEM 300 for use in a phased array antenna system, such as phased array antenna system 100 shown in FIG. 1. For example, FEM 300 may be included in a serially fed chain of FEMs, such as FEM series 110 shown in FIG. 1. FEM 300 can assume any position within such a series, e.g., FEM 300 can be a first FEM in a serially fed chain, a last FEM in a serially fed chain, or FEM 300 can be a FEM at any position in between. FEM 300 can be similar to and perform similar functions to FEM 106 shown in FIG. 1. FEM 300 transmits and/or receives RF signals, or beams, on an RF serial channel of the serially fed chain via an RF serial port 302 and an RF serial port 304, which electrically couple FEM 300 with a prior and/or subsequent FEM in the FEM series, or, e.g., a DBF such as DBF 104 shown in FIG. 1. Similarly, FEM 300 includes transmit (Tx) ports 306 and receive (Rx) ports 308 through which beams are communicated to and from a plurality of antenna elements 310. The plurality of antenna elements 310 can be similar to and perform similar functions to the plurality of antenna elements 108 shown in FIG. 1 or antenna elements 202 shown in FIG. 2.

RF serial port 302 and RF serial port 304 of FEM 300 compose opposing ends of an RF serial channel through FEM 300 that further includes a signal conditioning stage 312, an RF interchange 314, and another signal conditioning stage 316. The RF serial channel extends between RF serial port 302 and RF serial port 304, and is configured to propagate (i) one beam for transmission from RF serial port 302 to RF serial port 304, (ii) one beam, received over the air, from RF serial port 304 to RF serial port 302, (iii) one beam from RF serial port 302 to antenna elements 310 for transmission over the air, and (iv) one beam received over the air from antenna elements 310 to RF serial port 302. In alternative embodiments, FEM 300 may include a second RF serial channel for propagating a second beam.

RF interchange 314 combines signals, in a receive (Rx) mode, received over the air at the plurality of antenna elements 310 and routed to RF interchange through bidirectional ports 318. RF interchange 314 distributes signals, to be emitted by the plurality of antenna elements 310 in a transmit (Tx) mode, through bidirectional ports 318.

RF serial port 302 and RF serial port 304, and the RF serial channel extending therebetween, are illustrated in FIG. 3A employing differential transmission lines. In alternative embodiments, RF serial ports 302 and RF serial port 304, and the RF serial channel extending therebetween, are implemented with single ended transmission lines.

More specifically, referring to the differential implementation shown in FIG. 3A in the Tx mode, RF interchange 314 can distribute an RF signal, i.e., a differential signal, received at RF serial port 302 of FEM 300 and conditioned by signal conditioning stage 312, to bidirectional ports 318 and RF serial port 304 of FEM 300. For example, in Tx mode, the differential RF signal, or beam, may be received at RF serial port 302, propagate through signal conditioning stage 312, and enter RF interchange 314 for distribution. The signal is distributed to each of the plurality of antenna elements 310 through respective bidirectional ports 318. As illustrated in FIG. 3A, the differential RF signal can be converted to a single-ended signal by the respective PA 320. In some implementations, differential to single-ended conversion may be performed subsequent to the respective PA 320.

The RF signals distributed for transmission over the air by each antenna element 310 can be amplified in one or more stages along the path from RF serial port 302 to plurality of antenna elements 310. For example, RF signals may be amplified by a respective PA 320, a bidirectional amplifier 326 preceding respective PA 320, a bidirectional amplifier 328 at bidirectional ports 318, or a bidirectional amplifier 330 within signal conditioning stage 312, or any combination of two or more of PA 320, bidirectional amplifier 326, bidirectional amplifier 328, and bidirectional amplifier 330. As shown in the embodiment of FIG. 3A, respective PA 320, bidirectional amplifier 326, bidirectional amplifier 328, and bidirectional amplifier 330 are all included. Additionally, in at least some embodiments, RF signals distributed for transmission over the air by each antenna element 310 can be phase shifted by a respective phase shifter 322 before transmission through a respective Tx port 306 to a corresponding one of the plurality of antenna elements 310. Phase shifters 322 can apply a phase shift to the corresponding distributed signals to generate a coherently combined transmitted signal (i.e., emitted by the phased array) in a desired direction (e.g., the beam steering direction). The plurality of antenna elements 310 coupled to Tx ports 306 emit, or radiate, the amplified and/or phase adjusted RF signal.

In the Rx mode, the RF interchange 314 combines respective RF signals received at RF serial port 304 and conditioned by the signal conditioning stage 316, with signals received over the air by each of the plurality of antenna elements 310. In receive mode, an RF signal, or beam, is received over the air by antenna elements 310. The RF signals from each of the plurality of antenna elements 310 are routed through respective Rx ports 308 toward RF interchange 314 for combination with signals received through RF serial port 304, i.e., from one or more subsequent FEMs in the series. The received signal from each of the plurality of antenna elements 310 can be amplified in one or more stages along the path from ports 308 at plurality of antenna elements 310 to RF serial port 302. For example, received signals may be amplified by low noise amplifiers (LNAs) 324, bidirectional amplifier 326, bidirectional amplifier 328 at bidirectional ports 318, or bidirectional amplifier 330 within signal conditioning stage 312, or any combination of two or more of LNA 324, bidirectional amplifier 326, bidirectional amplifier 328, and bidirectional amplifier 330. Additionally, in at least some embodiments, received signals are phase shifted by phase shifters 322. As illustrated in FIG. 3A, the differential RF signal can be converted from a single-ended signal to a differential signal by the respective LNA 324 for each antenna element. In some implementations, single-ended to differential conversion may be performed subsequent to the respective LNA 324.

Although the Rx signal path, as illustrated in FIG. 3A, includes a single LNA 324 and a single phase shifter 322 coupled to each of the plurality of antenna elements 310, in some cases, a separate phase shifter 322 and/or LNA 324 can be coupled to each of the plurality of antenna elements 310 for receiving multiple beams. Similarly, the Tx signal path, as illustrated in FIG. 3A, can include a separate phase shifter 322 for transmitting and/or multiple PA 320 can be coupled to each of the plurality of antenna elements 310 for transmitting multiple beams. Likewise, signal conditioning stage 312, RF interchange 314, and signal conditioning stage 316 may be implemented with multiple differential signal paths for combining, routing, and conditioning multiple received beams, and for conditioning and distributing multiple beams for transmission.

RF interchange 314, when transmitting, splits RF signals for transmission and distributes them to bidirectional ports 318. When receiving, RF interchange combines RF signals for routing to RF serial port 302. Each time a beam is split or combined within RF interchange 314, the signal experiences a power loss. For example, when splitting an RF signal received at an input port to two output ports, the power is divided approximately equally, effectively exhibiting a 3 dB loss from the input port to either one output port. When combining, for example, two signals, the combined signal may exhibit a small, but non-zero, power loss. Signal conditioning stage 312 and signal conditioning stage 316, in certain example embodiments, may include components such as, for example, and without limitation, bidirectional amplifiers (such as bidirectional amplifier 330), additional LNAs, PAs, variable gain amplifiers (VGAs), transformers, differential amplifiers, and/or phase shifters (e.g., for Rx and/or Tx). In certain embodiments, signal conditioning stage 312 and signal conditioning stage 316 include active buffers, such as bidirectional amplifier 330, to compensate for losses exhibited by, e.g., transmission lines, RF interchange 314, and for losses incurred when each beam is split or combined. Active buffers also can increase the isolation with the external environment (e.g., the rest of the PCB). FEM 300 can be configured, e.g., utilizing signal conditioning stages 312 and 316, to provide an equal gain among each of the plurality of antenna elements 310 and, furthermore, equal gain among multiple instances of FEM 300 connected in series, such as multiple instances of FEM 106 in FEM series 110, shown in FIG. 1.

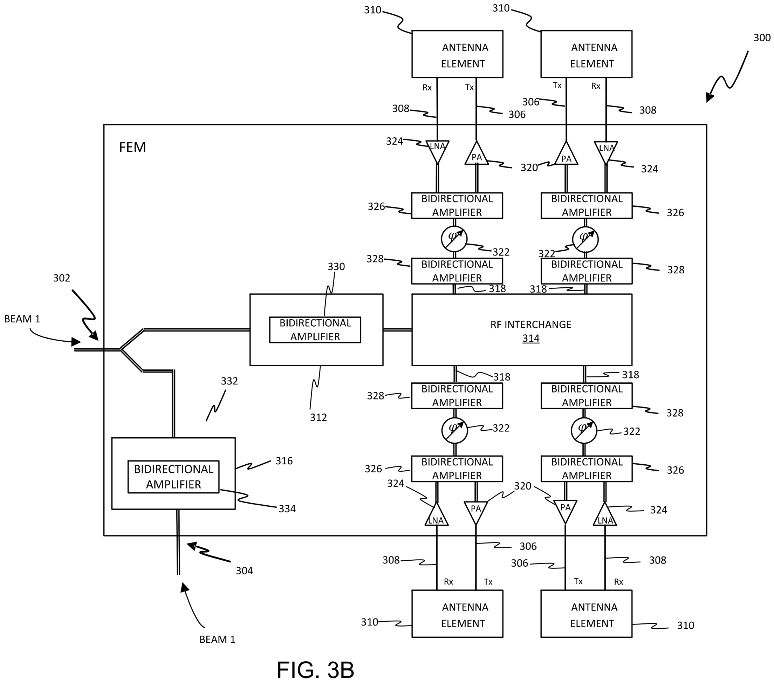

FIG. 3B is a functional block diagram of another example embodiment of FEM 300. As shown in FIG. 3B, FEM 300 operates generally the same as the embodiment of FEM 300 shown in FIG. 3A, but includes a through path 332 to RF serial port 304 that bypasses RF interchange 314. Through path 332 splits from RF serial port 302 and includes signal conditioning stage 316, which can include, for example, a bidirectional amplifier 334. Employing bidirectional amplifier 334 on through path 332, i.e., instead of independent transmit and receive amplifiers, reduces the output capacitance of the through path, which loads the through path less and makes through path 332 easier to drive.

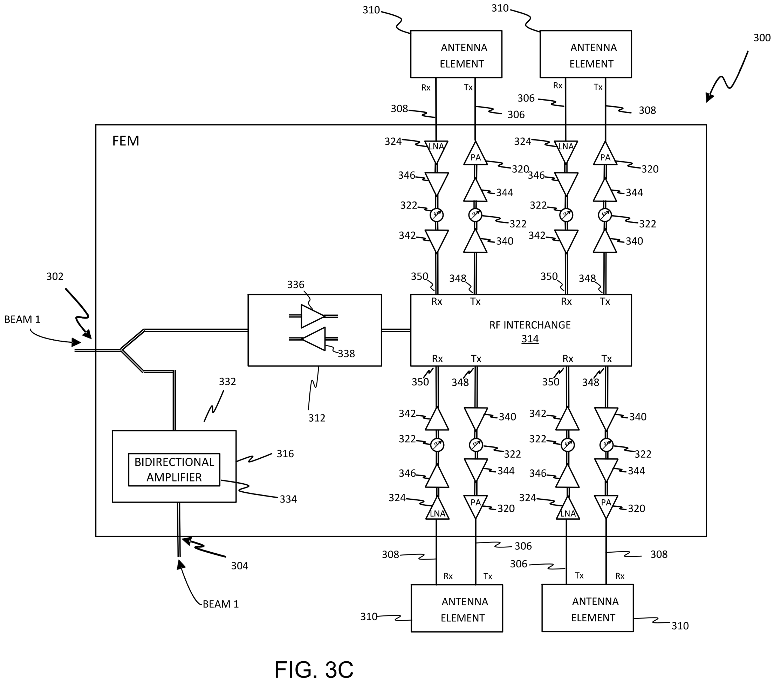

FIG. 3C is a functional block diagram of another example embodiment of FEM 300. As shown in FIG. 3C, FEM 300 operates generally the same as the embodiment of FEM 300 shown in FIG. 3B, but includes independent transmit and receive amplifiers in place of bidirectional amplifier 326, bidirectional amplifier 328, and bidirectional amplifier 330. More specifically, bidirectional amplifier 330 is replaced by a neutralized transmit amplifier 336 that is independent of a neutralized receive amplifier 338; bidirectional amplifier 328 is replaced by a neutralized transmit amplifier 340 that is independent of a neutralized receive amplifier 342; and bidirectional amplifier 326 is replaced by a neutralized transmit amplifier 344 that is independent of a neutralized receive amplifier 346. Likewise, because RF interchange 314 drives the transmit antenna paths, e.g., through neutralized transmit amplifier 340, independent of the receive antenna paths, e.g., through neutralized receive amplifier 342, RF interchange 314 includes transmit ports 348 that are independent of receive ports 350 for each of the antenna paths and their corresponding antenna elements 310.

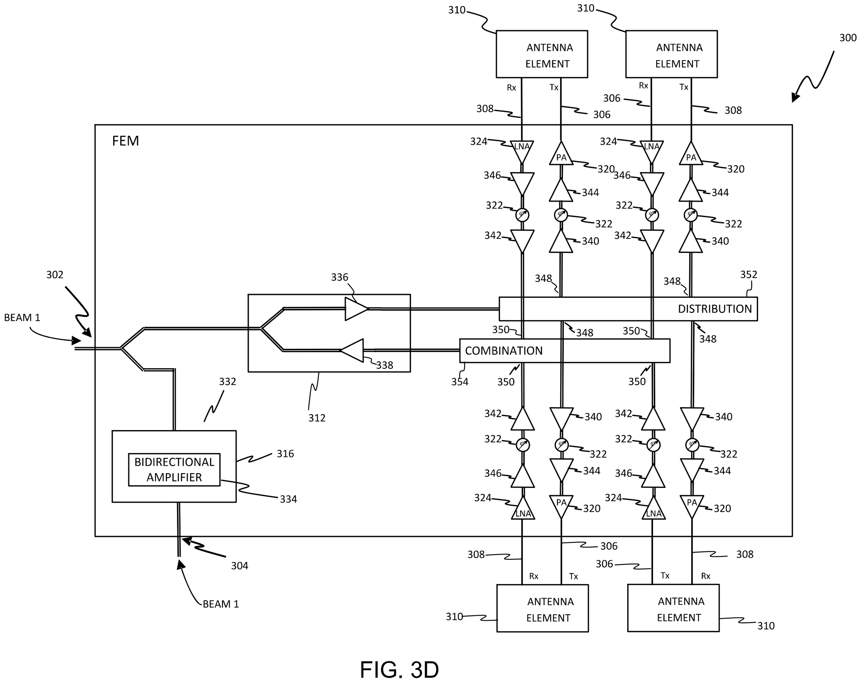

FIG. 3D is a functional block diagram of yet another example embodiment of FEM 300. As shown in FIG. 3D, FEM 300 operates generally the same as the embodiment of FEM 300 shown in FIG. 3C, but includes independent transmit and receive RF interchanges, i.e., a distribution network 352 for transmitting and a combination network 354 for receiving, instead of RF interchange 314, which is combined and bidirectional. Distribution network 352 is coupled to neutralized transmit amplifier 336 and includes transmit ports 348 corresponding to the transmit antenna paths for antenna elements 310. Combination network 354 is coupled to neutralized receive amplifier 338 and includes receive ports 350 corresponding to the receive antenna paths for antenna elements 310.

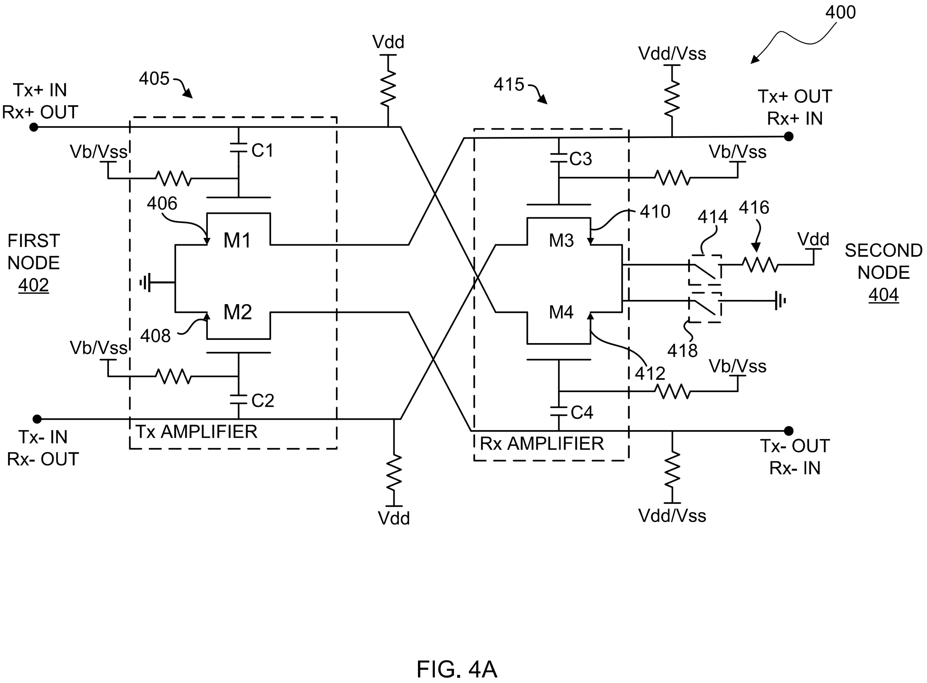

FIG. 4A is a schematic diagram of an example bidirectional differential amplifier 400 in accordance with some examples of the present disclosure. Amplifier 400 may be employed, for example, as bidirectional amplifier 326, bidirectional amplifier 328, or bidirectional amplifier 330 shown in FIGS. 3A-3C. Amplifier 400 includes a transmit (Tx) amplifier 405 and a receive (Rx) amplifier 415, each coupled between a first differential node 402 and a second differential node 404. Generally, bidirectional differential amplifier 400 is configured for differential signaling.

While the example of FIG. 4A illustrates a Tx amplifier 405 and an Rx amplifier implemented using MOSFETs, it should be understood that the Tx amplifier 405 and Rx amplifier 415 may be implemented, for example, using BJTs without departing from the scope of the present disclosure. The Tx amplifier 405 and Rx amplifier 415, moreover, can be implemented, for example, as common-emitter amplifiers (e.g., when implemented with BJTs) or common-source amplifiers (e.g., when implemented with MOSFETs).

In an Rx mode, RF signals received at the Rx+ IN port of the second differential node 404 will be 180 degrees (180°) out of phase with RF signals received at the Rx- IN port of the second differential node 404, which may also be referred to as out of phase, opposite phase, or opposite polarity. The Rx amplifier 415 is configured to amplify the differential signal received at the second node 404. Accordingly, the output of the Rx amplifier 415 at the first differential node 402 between the Rx+ OUT port and the Rx- OUT port is fully differential.

In a Tx mode, RF signals received at the first differential node 402 for transmission are also differential such that the RF signal at the Tx+ IN node is 180 degrees (180°) out of phase with the RF signal at the Tx- IN node. The signal produced by pseudo-differential amplification of the RF signals received at the first differential node can result in an output of the Tx amplifier 405 at the second differential node 404 that is fully differential.

As shown in FIG. 4A, the Tx Amplifier 405 includes two common-source amplifiers implemented with a MOSFET 406, and a MOSFET 408. The gates of the MOSFETs 406, 408 are capacitively coupled to the first differential node 402 through capacitors C1 and C2, respectively. The source terminals of the MOSFETs are grounded, resulting in a pseudo-differential operation of the first amplifier 405. As illustrated in FIG. 4A, the drain terminals of the MOSFETs 406, 408 are coupled to the second differential node 404.

As shown in FIG. 4A, the Rx Amplifier 415 includes two common-source amplifiers implemented with a MOSFET 410 and a MOSFET 412. The gates of the MOSFETs 410, 412 are capacitively coupled to the second differential node 404 through capacitors C3 and C4, respectively. The drain terminals of the MOSFETs 410, 412 are cross-coupled to the first differential node 402. That is, the gate of MOSFET 410 is coupled with the positive line of the second differential node 404, while the drain of MOSFET 410 is coupled with the negative line of the first differential node 402. Likewise, the gate of MOSFET 412 is coupled with the negative line of the second differential node 404 and the drain of MOSFET 412 is coupled with the positive line of the first differential node 402. The source terminals of the MOSFETs are selectively coupled, via a switch 414, to a voltage source, i.e., when in transmit mode, or, via a switch 418, to ground, i.e., when in receive mode.

The first differential node 402 operates as a differential input node when in transmit mode and a differential output node when in receive mode, and includes a positive line (e.g., Tx+ IN, Rx+ OUT), or port, and a negative line (e.g., Tx- IN, RX- OUT), or port. Each of the positive and negative lines of the first differential node 402 is biased to a DC bias voltage, Vdd. As illustrated in FIG. 4A, a resistor may be disposed between the DC bias voltage source and each respective port (e.g., the positive port, the negative port) of the first differential node 402.

The second differential node 404 operates as a differential input node when in receive mode and a differential output node when in transmit mode, and includes a positive line (e.g., Rx+ IN, Tx+ OUT), or port, and a negative line (e.g., Rx- IN, Tx- OUT), or port. The positive line and the negative line of the second differential node 404 are each also biased by a DC bias voltage. In some implementations, the bias level can be selectively changed for transmit mode versus receive mode. For example, when in transmit mode, the DC bias voltage, Vdd, is employed to bias the second differential node 404 and in turn to provide a drain to source bias $V_{ds}$ (i.e., a reference drain current) to the MOSFETs 406, 408. In contrast, when in receive mode, the positive port and the negative port of the second differential node 404 can be biased to a reference voltage (e.g., ground) to ensure the MOSFETs 406, 408 operate in their cutoff region.

Generally, transistors such as MOSFETs and BJTs exhibit inherent parasitic capacitances due to their physical structure. These capacitances, although unintended, can impact high-frequency performance of circuits, including amplifiers. The primary parasitic capacitances for MOSFETs are gate-to-source capacitance, gate-to-drain capacitance, and drain-to-body capacitance. Likewise, BJTs exhibit collector-base capacitance (e.g., $C_\mu$), base-emitter capacitance (e.g., $C_\pi$), and collector-emitter capacitance. Parasitic capacitances in amplifiers, such as the Tx amplifier and Rx amplifier shown in FIG. 4A, can impact bandwidth, increase input and output capacitances, and reduce stability. In particular, parasitic capacitances exhibited between an output and an input of an amplifier circuit, or between ungrounded nodes of a transistor, can introduce a destabilizing feedback and introduces additional input and output capacitances for the amplifier. For example, the gate-to-drain capacitance ($C_{gd}$) inherent in a common-source amplifier (i.e., implemented with a MOSFET) extends from the input, i.e., the gate, to the output, i.e., the drain, of the transistor, which operates as a capacitive feedback circuit on the amplifier. Moreover, due to the Miller effect, the equivalent input capacitance is greater than the parasitic capacitance, $C_{gd}$. The effects of parasitic capacitances in amplifiers can be mitigated, for example, by feedback compensation such as neutralization, or "Miller neutralization." Generally, Miller neutralization introduces a complementary feedback that is 180 degrees out of phase to "neutralize" the parasitic capacitive feedback.

Generally, as shown in the embodiment of FIG. 4A, MOSFETs 406, 408, 410, and 412 form a shared network of transistors for both the transmit mode and the receive mode. For example, when in transmit mode, MOSFETs 406 and 408 of the Tx amplifier operate as amplifiers (e.g., transconductance devices) while MOSFETs 410 and 412 provide a neutralizing capacitance. Conversely, when in receive mode, MOSFETs 410 and 412 of the Rx amplifier operate as amplifiers (e.g., transconductance devices) while MOSFETs 406 and 408 provide a neutralizing capacitance.

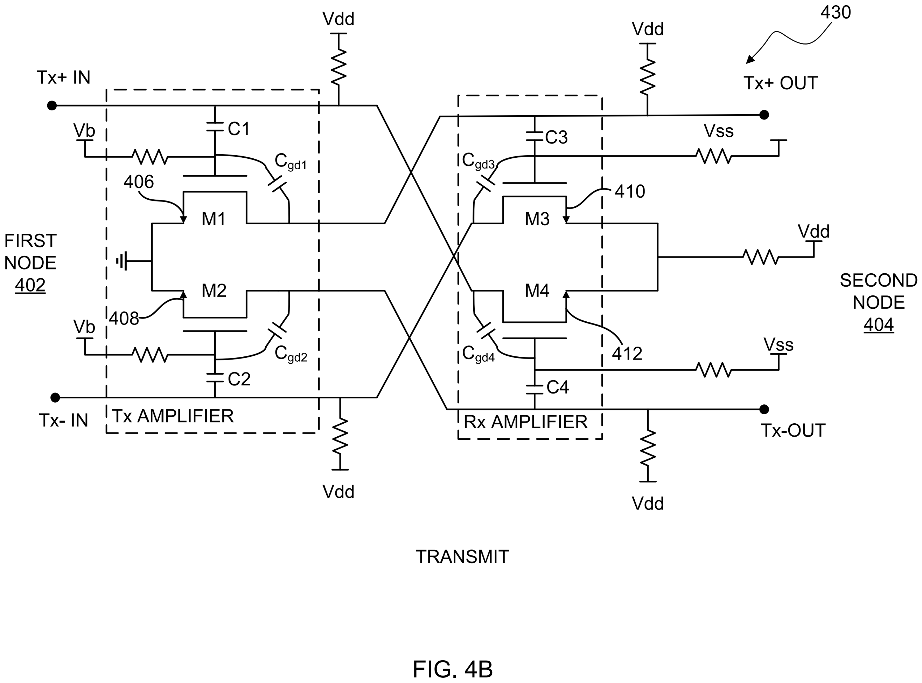

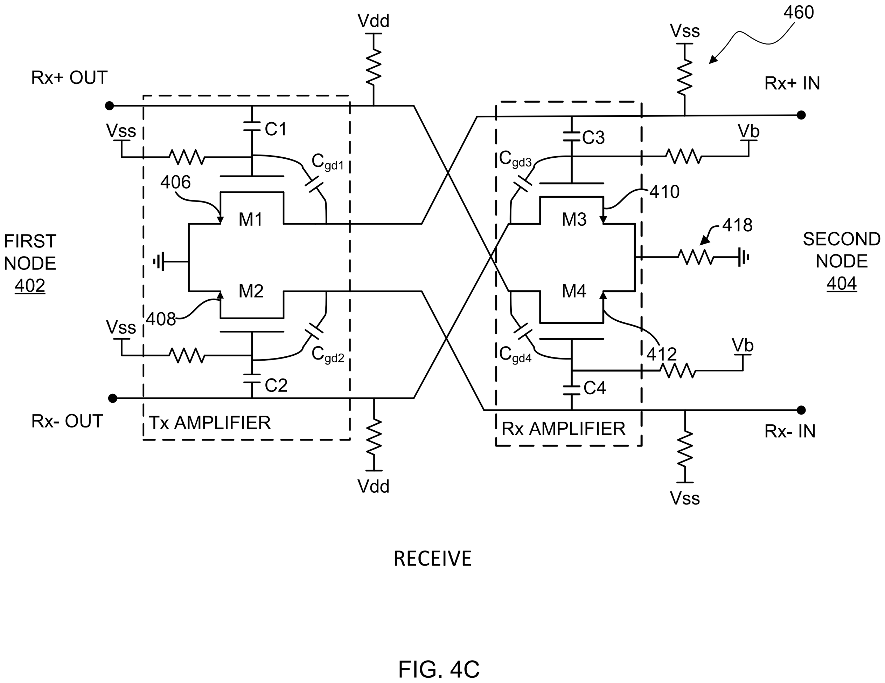

FIG. 4B is a schematic diagram 430 of the bidirectional differential amplifier 400 shown in FIG. 4A when operating in transmit mode. FIG. 4C is a schematic diagram of the bidirectional differential amplifier shown in FIG. 4A when operating in receive mode.

Referring to FIG. 4B, when in transmit mode, the Tx amplifier 405 can be biased in a saturation region and the Rx amplifier can be biased in a cut-off region. In particular, a bias voltage, Vb, is applied at the gates of MOSFETs 406 and 408. The drain terminals of the MOSFETs 406 and 408 are coupled to the second differential node 404 and biased to Vdd. Common, or source, terminals of the MOSFETs 406 and 408 are coupled to ground. MOSFETs 406 and 408 are in saturation and operate in a pseudo-differential configuration to amplify a differential input signal received at the first differential node 402.

As shown in FIG. 4B, the MOSFETs 410 and 412 can be operated in a cut-off region during the transmit mode. MOSFETs 410 and 412 are biased at their gates by a low voltage level Vss (e.g., ground). Switch 414 is actuated to couple a supply voltage Vdd to the source terminals of MOSFETs 410 and 412. As a result, the voltage gate-to-source ($V_{gs}$) of the MOSFETs 410 and 412 is negative to ensure MOSFETs 410 and 412 are operating in the cut-off region regardless of the signal swing of the Tx amplifier 405 output at the second node 404. Consequently, MOSFETs 410 and 412 of the Rx amplifier behave as capacitors that can be used to provide neutralization of the parasitic capacitances of the MOSFETs 406 and 408 when in transmit mode. As illustrated in FIG. 4A, a resistor 416 may be disposed between the supply voltage Vdd source and switch 414.

The parasitic capacitances of the transistors of the Tx amplifier 405, i.e., MOSFETs 406 and 408 may introduce a negative feedback, increase the output capacitance of the Tx amplifier, and/or reduce stability of the Tx amplifier, e.g., over frequency. For example, the parasitic capacitances of MOSFETs 406 and 408 from gate to drain, (e.g., $C_{gd1}$, $C_{gd2}$), introduce a capacitive feedback from the output to input, e.g., from the second differential node 404 to the first differential node 402, from the drains of MOSFETs 406 and 408 to the gates of MOSFETs 406 and 408, respectively. In addition, the equivalent input capacitance of the MOSFETs 406 and 408 can be increased due to the amplification provided by the MOSFETs 406 and 408. The MOSFETs 410 and 412 of the Rx amplifier 415 can be used to neutralize the feedback caused by the parasitic capacitances (e.g., $C_{gd1}$, $C_{gd2}$) of the MOSFETs 406 and 408 by feeding back a signal that is 180 degrees out of phase with the feedback through the parasitic capacitances of the MOSFETs 406 and 408, i.e., Miller neutralization.

The parasitic capacitance $C_{gd3}$ of the MOSFET 410 is coupled in series with the AC coupling capacitor C3 between the positive port (e.g., Tx+ OUT) of the second node 404 (e.g., the output of the MOSFET 406) and the negative port (e.g., Tx- IN) of the first node 402. Similarly, the parasitic capacitance $C_{gd4}$ of the MOSFET 412 is coupled in series with the AC coupling capacitor C4 between the negative port (e.g., Tx- OUT) of the second node 404 and the positive port (e.g., Tx+ IN) of the first node 402. The MOSFETs 410 and 412 can be sized to have parasitic capacitances $C_{gd3}$ and $C_{gd4}$,

respectively, with a capacitance value of Cgd. Generally, given two or more capacitances in series, the total capacitance is no more than the smallest capacitance in the series. In some cases, the capacitance of AC coupling capacitors C3 and C4 can be selected to be much larger than Cgd such that the parasitic capacitances $C_{gd3}$ and $C_{gd4}$ dominate the capacitive effect. For example, as shown in Equation (1) below, the series capacitance is the reciprocal of the sum of reciprocals of the individual capacitors. Accordingly, for MOSFET 410, for example, as shown in FIGS. 4A-4C:

$$\frac{1}{\frac{1}{Cgd_3}+\frac{1}{C3}} < Cgd_3 \qquad\qquad (1)$$

Accordingly, for MOSFET 410, C3 can be selected such that the equivalent series capacitance can be approximately equal to the relatively small parasitic capacitance $C_{gd3}$, and the AC coupling capacitance C3 can be ignored. Likewise, for MOSFET 412, AC coupling capacticance C4 can be selected such that the equivalent series capacitance can be approximately equal to the relatively small parasitic capacitance $C_{gd4}$.

As noted above, the neutralizing feedback provided by the capacitances $C_{gd3}$, $C_{gd4}$, can be utilized to neutralize parasitic capacitances $C_{gd1}$, $C_{gd2}$ of the MOSFETs 406 and 408. For example, the neutralizing capacitor $C_{gd4}$ of the MOSFET 412 is positioned between the drain of the MOSFET 408 and the gate of the MOSET 406 while the parasitic capacitor $C_{gd1}$ of the MOSFET 406 is positioned between the drain of the MOSFET 406 and the gate of the MOSET 406. The amplified signal at the drain of the MOSFET 408 coupled to $C_{gd4}$ is 180 degrees out of phase with the amplified signal at the drain of the MOSFET 406 coupled to parasitic capacitance $C_{gd1}$, thereby at least partially neutralizing the parasitic capacitance $C_{gd1}$ of the MOSFET 406.

Similarly, the neutralizing capacitor $C_{gd3}$ of the MOSFET 410 is positioned between the drain of the MOSFET 406 and the gate of the MOSFET 408 while the parasitic capacitor $C_{gd2}$ of the MOSFET 408 is positioned between the drain of the MOSFET 408 and the gate of the MOSFET 408. The amplified signal at the drain of the MOSFET 406 coupled to $C_{gd3}$ is 180 degrees out of phase with the amplified signal at the drain of the MOSFET 408 coupled to parasitic capacitance $C_{gd2}$, thereby at least partially neutralizing the parasitic capacitance $C_{gd2}$ of the MOSFET 408.

In some cases, the sizing of the MOSFETs 410 and 412 for the Rx amplifier 415 (and resulting parasitic capacitance values $C_{gd3}$, $C_{gd4}$), can be selected to match the sizing of the transistors of the Tx amplifier 405 (and resulting parasitic capacitance values $C_{gd1}$, $C_{gd2}$) to achieve a maximum amount of neutralization. However, care should be taken to ensure that the neutralization capacitance does not result in positive feedback, which can lead to instability (e.g., oscillation).

Referring to FIG. 4C, when in receive mode, the MOSFETs 410 and 412 of the Rx amplifier 415 can be biased into a saturation region and the MOSFETs 406 and 408 of the Tx amplifier can be biased in a cut-off region. In particular, a bias voltage, Vb, is applied at the gates of MOSFETs 410 and 412. The drain terminals of the MOSFETS 410 and 412 are cross-coupled to the first differential node 402 and biased to Vdd.

Switch 418 is actuated to couple the source terminals of MOSFETs 410 and 412 to ground. In some cases, the switch resistance of the switch 418 can provide rejection of the common mode signal at the second node 404 such that the MOSFETs 410 and 412 operate as a differential amplifier. The differential amplifier formed by MOSFETs 410 and 412 can produce a differential output signal at the first node 402 based on a differential input signal received at the second node 404.

As shown in FIG. 4C, the MOSFETs 406 and 408 of the Tx amplifier 405 can be operated in a cut-off region during the receive mode. MOSFETs 406 and 408 are biased at their gates by a low voltage level Vss, with source terminals coupled to ground. Because the second differential node 404 is biased to Vss when in receive mode, the drain terminals of MOSFETs 406 and 408 are also biased to Vss when in receive mode. Consequently, MOSFETs 406 and 408 are effectively biased equally at their gates and drains, i.e., at Vss, which prevents the MOSFETs 406 and 408 from entering the saturation region. Accordingly, MOSFETs 406 and 408 of the Tx amplifier 405 can be used to provide neutralization of the parasitic capacitances of the MOSFETS 410 and 412 when in receive mode.

The parasitic capacitances of the transistors of the Rx amplifier 415, i.e., MOSFETs 410 and 412 may introduce a negative feedback, increase the output capacitance of the Rx amplifier, and/or reduce stability of the Rx amplifier, e.g., over frequency. For example, the parasitic capacitances of MOSFETs 410 and 412 from gate to drain, Cgd, introduce a capacitive feedback from the output to input, e.g., from the first differential node 402 to the second differential node 404, from the drains of MOSFETs 410 and 412 to the gates of MOSFETs 412 and 410, respectively. In addition, the equivalent input capacitance of the MOSFETs 412 and 410 can be increased due to the amplification provided by the MOSFETs 412 and 410. The MOSFETs 406 and 408 of the Tx amplifier 405 can be used to neutralize the feedback caused by the parasitic capacitances (e.g., $C_{gd3}$, $C_{gd4}$) of the MOSFETs 412 and 410 by feeding back a signal that is 180 degrees out of phase with the feedback through the parasitic capacitances of the MOSFETs 412 and 410, i.e., Miller neutralization.

The parasitic capacitance $C_{gd1}$ of the MOSFET 406 is coupled in series with the AC coupling capacitor C1 between the positive port (e.g., Rx+ OUT) of the first node 402 (e.g., the output of the MOSFET 412) and the positive port (e.g., Rx+ IN) of the second node 404. Similarly, the parasitic capacitance $C_{gd2}$ of the MOSFET 408 is coupled in series with the AC coupling capacitor C2 between the negative port (e.g., Rx- OUT) of the first node 402 and the negative port (e.g., Rx- IN) of the second node 404. As shown in Equation (1) above, the series capacitance is the reciprocal of the sum of reciprocals of the individual capacitors.

As noted above, the MOSFETs 406 and 408 can be sized to have parasitic capacitances $C_{gd1}$ and $C_{gd2}$, respectively, with a capacitance value of Cgd. In some cases, the capacitance of AC coupling capacitors C1 and C2 can be selected to be much larger than Cgd such that the parasitic capacitances $C_{gd1}$ and $C_{gd2}$ dominate the capacitive effect.

Accordingly, for MOSFET 406, C1 can be selected such that the equivalent series capacitance can be approximately equal to the relatively small parasitic capacitance $C_{gd1}$, and the AC coupling capacitance C1 can be ignored. Likewise, for MOSFET 408, AC coupling capacitance C2 can be selected such that the equivalent series capacitance can be approximately equal to the relatively small parasitic capacitance $C_{gd2}$.

As noted above, the neutralizing feedback provided by the capacitances $C_{gd1}$, $C_{gd2}$, can be utilized to neutralize parasitic capacitances $C_{gd3}$, $C_{gd4}$ of the MOSFETs 410 and 412. For example, the neutralizing capacitor $C_{gd1}$ of the MOSFET 406 is positioned between the drain of the MOSFET 412 and the gate of the MOSET 410 while the parasitic capacitor $C_{gd3}$ of the MOSFET 410 is positioned between the drain of the MOSFET 410 and the gate of the MOSET 410. The amplified signal at the drain of the MOSFET 412 coupled to $C_{gd1}$ is 180 degrees out of phase with the amplified signal at the drain of the MOSFET 410 coupled to parasitic capacitance $C_{gd3}$, thereby at least partially neutralizing the parasitic capacitance $C_{gd3}$ of the MOSFET 410.

Similarly, the neutralizing capacitor $C_{gd2}$ of the MOSFET 408 is positioned between the drain of the MOSFET 410 and the gate of the MOSFET 412 while the parasitic capacitor $C_{gd4}$ of the MOSFET 412 is positioned between the drain of the MOSFET 412 and the gate of the MOSFET 412. The amplified signal at the drain of the MOSFET 410 coupled to $C_{gd2}$ is 180 degrees out of phase with the amplified signal at the drain of the MOSFET 412 coupled to parasitic capacitance $C_{gd4}$, thereby at least partially neutralizing the parasitic capacitance $C_{gd4}$ of the MOSFET 412.

In some cases, the sizing of the MOSFETs 406 and 408 for the Tx amplifier 405 (and resulting parasitic capacitance values $C_{gd1}$, $C_{gd2}$), can be selected to match the sizing of the transistors of the Rx amplifier 415 (and resulting parasitic capacitance values $C_{gd3}$, $C_{gd4}$) to achieve a maximum amount of neutralization. However, care should be taken to ensure that the neutralization capacitance does not result in positive feedback, which can lead to instability (e.g., oscillation).

The following disclosure sets out certain aspects of the disclosed invention in the form of clauses corresponding to the claims. These clauses are provided to ensure explicit and literal support for the claims as filed, and for any future amendments, under the requirements of various jurisdictions. Each clause should be understood as forming part of the description and as an independent disclosure of inventive subject matter.

In some embodiments, a bidirectional differential amplifier comprises a first differential node configured as a differential transmit input node for a transmit mode and a differential receive output node for a receive mode; a second differential node configured as a differential transmit output node for the transmit mode and a differential receive input node for the receive mode; a transmit amplifier comprising a first transistor and a second transistor coupled between the first differential node and the second differential node and configured to produce a differential output transmit signal at the second differential node, the first transistor and the second transistor together including: a transmit pseudo-differential input coupled with a first bias voltage source and capacitively coupled with the first differential node; and a transmit differential output coupled with the second differential node; and a receive amplifier comprising a third transistor and a fourth transistor coupled between the first differential node and the second differential node and configured to produce a differential output receive signal at the first differential node, the third transistor and the fourth transistor including: a receive differential input coupled with a second bias voltage source and capacitively coupled with the second differential node; a receive differential output cross-coupled with the first differential node; and common terminals configured to be selectively coupled with ground when in the receive mode, and with a voltage supply when in the transmit mode; wherein, when in the transmit mode, the third transistor and the fourth transistor are configured to supply a neutralizing transmit feedback to the first differential node that is opposite in phase relative to the differential output transmit signal; and wherein, when in the receive mode, the first transistor and the second transistor are configured to supply a neutralizing receive feedback to the second differential node that is opposite in phase relative to the differential output receive signal.

In some embodiments, the first transistor, the second transistor, the third transistor, and the fourth transistor comprise MOSFETs.

In some embodiments, the first transistor, the second transistor, the third transistor, and the fourth transistor comprise BJTs.

In some embodiments, a first port of the first differential node and a second port of the first differential node are each respectively configured to be biased by the voltage supply, and wherein a third port of the second differential node and a fourth port of the second differential node are each respectively configured to be biased by the voltage supply when in the transmit mode and by a reference voltage when in the receive mode.

In some embodiments, the first bias voltage source is configured to: supply a first bias voltage to the transmit pseudo-differential input when in the transmit mode; and supply a second bias voltage to the transmit pseudo-differential input when in the receive mode, the second bias voltage being different from the first bias voltage.

In some embodiments, the second bias voltage source is configured to: supply a third bias voltage to the receive differential input when in the receive mode; and supply a fourth bias voltage to the receive differential input when in the transmit mode, the fourth bias voltage being different from the third bias voltage.

In some embodiments, a front end module for a phased array antenna comprises a first RF serial port configured to receive an RF transmit signal for transmission over a channel when in a transmit mode and an RF receive signal received over the channel when in a receive mode; an RF interchange coupled in series with the first RF serial port and configured to: distribute the RF transmit signal to one or more antenna paths corresponding to one or more antenna elements when in the transmit mode; and combine the RF receive signal from the one or more antenna paths when in the receive mode; a second RF serial port configured to feed through the RF transmit signal to a second front end module when in the transmit mode and feed through the RF receive signal from the second front end module when in the receive mode; and a bidirectional amplifier coupled between the first RF serial port and the second RF serial port.

In some embodiments, the bidirectional amplifier comprises: a first differential node configured as a differential transmit input node for a transmit mode and a differential receive output node for a receive mode; a second differential node configured as a differential transmit output node for the transmit mode and a differential receive input node for the receive mode; a transmit amplifier comprising a first transistor and a second transistor coupled between the first differential node and the second differential node and configured to produce a differential output transmit signal at the second differential node, the first transistor and the second transistor together including: a transmit pseudo-differential input coupled with a first bias voltage source and capacitively coupled with the first differential node; and a transmit differential output coupled with the second differential node; and a receive amplifier comprising a third transistor and a fourth transistor coupled between the first differential node and the second differential node and configured to produce a differential output receive signal at the first differential node, the third transistor and the fourth transistor including: a receive differential input coupled with a second bias voltage source and capacitively coupled with the second differential node; a receive differential output cross-coupled with the first differential node; and common terminals configured to be selectively coupled with ground when in the receive mode, and with a voltage supply when in the transmit mode; wherein, when in the transmit mode, the third transistor and the fourth transistor are configured to supply a neutralizing transmit feedback to the first differential node that is opposite in phase relative to the differential output transmit signal; and wherein, when in the receive mode, the first transistor and the second transistor are configured to supply a neutralizing receive feedback to the second differential node that is opposite in phase relative to the differential output receive signal.

In some embodiments, the bidirectional amplifier is coupled between the first RF serial port and the RF interchange.

In some embodiments, the front end module further comprises at least one bidirectional amplifier coupled in each of the one or more antenna paths corresponding to the one or more antenna elements.

In some embodiments, the bidirectional amplifier is coupled between the RF interchange and the second RF serial port.

In some embodiments, the front end module further comprises at least one bidirectional amplifier coupled in each of the one or more antenna paths corresponding to the one or more antenna elements.

In some embodiments, the front end module further comprises a second bidirectional amplifier coupled between the first RF serial port and the RF interchange.

In some embodiments, the front end module further comprises at least one bidirectional amplifier coupled in each of the one or more antenna paths corresponding to the one or more antenna elements.

In some embodiments, the front end module further comprises a second bidirectional amplifier coupled between the RF interchange and the second RF serial port.

In some embodiments, the front end module further comprises at least one bidirectional amplifier coupled in each of the one or more antenna paths corresponding to the one or more antenna elements.

In some embodiments, each of the one or more antenna paths comprises: a transmit antenna path including a power amplifier; and a receive antenna path including a low noise amplifier.

In some embodiments, the one or more antenna paths further comprise respective bidirectional antenna paths coupling the RF interchange to a corresponding bidirectional amplifier, wherein the corresponding bidirectional amplifier is further coupled to the transmit antenna path and the receive antenna path for a corresponding antenna element of the one or more antenna elements.

In some embodiments, the one or more antenna paths further comprise: respective bidirectional antenna paths including respective bidirectional phase shifters corresponding to the one or more antenna elements; respective first bidirectional amplifier coupled between the RF interchange and the respective bidirectional phase shifters; and respective second bidirectional amplifier coupled with the respective bidirectional phase shifters, and further coupled with the transmit antenna path and the receive antenna path.

In some embodiments, the transmit antenna path further includes a transmit phase shifter, and wherein the receive antenna path further includes a receive phase shifter.

The clauses above are provided for clarity of disclosure and support, and do not limit the scope of the appended claims. Features described in any one clause may be combined with features of any other clause, except where such combinations are clearly incompatible.

The term "computer-readable medium" includes, but is not limited to, portable or non-portable storage devices, optical storage devices, and various other mediums capable of storing, containing, or carrying instruction(s) and/or data. A computer-readable medium may include a non-transitory medium in which data can be stored and that does not include carrier waves and/or transitory electronic signals propagating wirelessly or over wired connections. Examples of a non-transitory medium may include, but are not limited to, a magnetic disk or tape, optical storage media such as compact disk (CD) or digital versatile disk (DVD), flash memory, memory or memory devices. A computer-readable medium may have stored thereon code and/or machine-executable instructions that may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, or the like.

In some embodiments the computer-readable storage devices, mediums, and memories can include a cable or wireless signal containing a bit stream and the like. However, when mentioned, non-transitory computer-readable storage media expressly exclude media such as energy, carrier signals, electromagnetic waves, and signals per se.

Specific details are provided in the description above to provide a thorough understanding of the embodiments and examples provided herein. However, it will be understood by one of ordinary skill in the art that the embodiments may be practiced without these specific details. For clarity of explanation, in some instances the present technology may be presented as including individual functional blocks comprising devices, device components, steps or routines in a method embodied in software, or combinations of hardware and software. Additional components may be used other than those shown in the figures and/or described herein. For example, circuits, systems, networks, processes, and other components may be shown as components in block diagram form in order not to obscure the embodiments in unnecessary detail. In other instances, well-known circuits, processes, algorithms, structures, and techniques may be shown without unnecessary detail in order to avoid obscuring the embodiments.

Individual embodiments may be described above as a process or method which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed but could have additional steps not included in a figure. A process may correspond to a method, a function, a procedure, a subroutine, a subprogram, etc. When a process corresponds to a function, its termination can correspond to a return of the function to the calling function or the main function.

Processes and methods according to the above-described examples can be implemented using computer-executable instructions that are stored or otherwise available from computer-readable media. Such instructions can include, for example, instructions and data that cause or otherwise configure a general purpose computer, special purpose computer, or a processing device to perform a certain function or group of functions. Portions of computer resources used can be accessible over a network. The computer executable instructions may be, for example, binaries, intermediate format instructions such as assembly language, firmware, source code. Examples of computer-readable media that may be used to store instructions, information used, and/or information created during methods according to described examples include magnetic or optical disks, flash memory, USB devices provided with non-volatile memory, networked storage devices, and so on.

Devices implementing processes and methods according to these disclosures can include hardware, software, firmware, middleware, microcode, hardware description languages, or any combination thereof, and can take any of a variety of form factors. When implemented in software, firmware, middleware, or microcode, the program code or code segments to perform the necessary tasks (e.g., a computer-program product) may be stored in a computer-readable or machine-readable medium. A processor(s) may perform the necessary tasks. Typical examples of form factors include laptops, smart phones, mobile phones, tablet devices or other small form factor personal computers, personal digital assistants, rackmount devices, standalone devices, embedded systems, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are example means for providing the functions described in the disclosure.

Many embodiments of the technology described herein may take the form of computer- or controller-executable instructions, including routines executed by a programmable computer or controller. Those skilled in the relevant art will appreciate that the technology can be practiced on computer/controller systems other than those shown and described above. The technology can be embodied in a special-purpose computer, controller or data processor that is specifically programmed, configured or constructed to perform one or more of the computer-executable instructions described above. Accordingly, the terms "computer" and "controller" as generally used herein refer to any data processor and can include Internet appliances and hand-held devices (including palm-top computers, wearable computers, cellular or mobile phones, multi-processor systems, processor-based or programmable consumer electronics, network computers, minicomputers and the like). Information handled by these computers can be presented at any suitable display medium, including an organic light emitting diode (OLED) display or liquid crystal display (LCD).

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

**Claims**

1. A bidirectional differential amplifier, comprising:

    a first differential node configured as a differential transmit input node for a transmit mode and a differential receive output node for a receive mode;
    a second differential node configured as a differential transmit output node for the transmit mode and a differential receive input node for the receive mode;
    a transmit amplifier comprising a first transistor and a second transistor coupled between the first differential node and the second differential node and configured to produce a differential output transmit signal at the second differential node, the first transistor and the second transistor together including:

       a transmit pseudo-differential input coupled with a first bias voltage source and capacitively coupled with the first differential node; and
       a transmit differential output coupled with the second differential node; and

    a receive amplifier comprising a third transistor and a fourth transistor coupled between the first differential node and the second differential node and configured to produce a differential output receive signal at the first differential node, the third transistor and the fourth transistor including:

       a receive differential input coupled with a second bias voltage source and capacitively coupled with the second differential node;
       a receive differential output cross-coupled with the first differential node; and
       common terminals configured to be selectively coupled with ground when in the receive mode, and with a voltage supply when in the transmit mode;

    wherein, when in the transmit mode, the third transistor and the fourth transistor are configured to supply a neutralizing transmit feedback to the first differential node that is opposite in phase relative to the differential output transmit signal; and
    wherein, when in the receive mode, the first transistor and the second transistor are configured to supply a neutralizing receive feedback to the second differential node that is opposite in phase relative to the differential output receive signal.

2. The bidirectional differential amplifier of claim 1, wherein the first transistor, the second transistor, the third transistor, and the fourth transistor comprise metal oxide semiconductor field effect transistors (MOSFETs).

3. The bidirectional differential amplifier of claim 1, wherein the first transistor, the second transistor, the third transistor, and the fourth transistor comprise bipolar junction transistors (BJTs).

4. The bidirectional differential amplifier of claim 1, wherein a first port of the first differential node and a second port of the first differential node are each respectively configured to be biased by the voltage supply, and wherein a third port of the second differential node and a fourth port of the second differential node are each respectively configured to be biased by the voltage supply when in the transmit mode and by a reference voltage when in the receive mode.

**5.** The bidirectional differential amplifier of claim 1, wherein the first bias voltage source is configured to:

supply a first bias voltage to the transmit pseudo-differential input when in the transmit mode; and
supply a second bias voltage to the transmit pseudo-differential input when in the receive mode, the second bias voltage being different from the first bias voltage.

**6.** The bidirectional differential amplifier of claim 1, wherein the second bias voltage source is configured to:

supply a third bias voltage to the receive differential input when in the receive mode; and
supply a fourth bias voltage to the receive differential input when in the transmit mode, the fourth bias voltage being different from the third bias voltage.

**7.** A front end module for a phased array antenna, the front end module comprising the bidirectional differential amplifier of claim 1 and further comprising:

a first radio frequency (RF) serial port configured to receive an RF transmit signal for transmission over a channel when in a transmit mode and an RF receive signal received over the channel when in a receive mode;
an RF interchange coupled in series with the first RF serial port and configured to:

distribute the RF transmit signal to one or more antenna paths corresponding to one or more antenna elements when in the transmit mode; and
combine the RF receive signal from the one or more antenna paths when in the receive mode;

a second RF serial port configured to feed through the RF transmit signal to a second front end module when in the transmit mode and feed through the RF receive signal from the second front end module when in the receive mode; and
the bidirectional amplifier coupled between the first RF serial port and the second RF serial port.

**8.** The front end module of claim 7, wherein the bidirectional amplifier is coupled between the first RF serial port and the RF interchange.

**9.** The front end module of claim 8 further comprising at least one bidirectional amplifier coupled in each of the one or more antenna paths corresponding to the one or more antenna elements.

**10.** The front end module of claim 7, wherein the bidirectional amplifier is coupled between the RF interchange and the second RF serial port.

**11.** The front end module of claim 10, further comprising at least one bidirectional amplifier coupled in each of the one or more antenna paths corresponding to the one or more antenna elements.

**12.** The front end module of claim 7, further comprising a second bidirectional amplifier coupled between the first RF serial port and the RF interchange.

**13.** The front end module of claim 12 further comprising at least one bidirectional amplifier coupled in each of the one or more antenna paths corresponding to the one or more antenna elements.

**14.** The front end module of claim 7, further comprising a second bidirectional amplifier coupled between the RF interchange and the second RF serial port.

**15.** The front end module of claim 14 further comprising at least one bidirectional amplifier coupled in each of the one or more antenna paths corresponding to the one or more antenna elements.

**16.** The front end module of claim 7, wherein each of the one or more antenna paths comprises:

a transmit antenna path including a power amplifier; and
a receive antenna path including a low noise amplifier.

**17.** The front end module of claim 16, wherein the one or more antenna paths further comprise respective bidirectional antenna paths coupling the RF interchange to a corresponding bidirectional amplifier, wherein the corresponding bidirectional amplifier is further coupled to the transmit antenna path and the receive antenna path for a corresponding antenna element of the one or more antenna elements.

18. The front end module of claim 16, wherein the one or more antenna paths further comprise:

respective bidirectional antenna paths including respective bidirectional phase shifters corresponding to the one or more antenna elements;
respective first bidirectional amplifier coupled between the RF interchange and the respective bidirectional phase shifters; and
respective second bidirectional amplifier coupled with the respective bidirectional phase shifters, and further coupled with the transmit antenna path and the receive antenna path.

19. The front end module of claim 16, wherein the transmit antenna path further includes a transmit phase shifter, and wherein the receive antenna path further includes a receive phase shifter.

FIG. 1

FIG. 2

FIG. 3A

EP 4 787 708 A1

FIG. 3B

FIG. 3C

EP 4 787 708 A1

FIG. 3D

FIG. 4A

FIG. 4B

RECEIVE

FIG. 4C

Europäisches
Patentamt
European
Patent Office
Office européen
des brevets

## EUROPEAN SEARCH REPORT

**Application Number**

EP 26 15 5121

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/126590 A1 (GONG YUNYI [US] ET AL) 29 April 2021 (2021-04-29) * paragraphs [0002] - [0061]; figures 1-8 * | 1-19 | INV. H03F3/195 H03F3/24 H03F3/45 H03F3/62 H03F3/72 ADD. H04B1/44 |
| A | CN 107 566 009 A (SUZHOU WEIFA SEMICONDUCTOR CO LTD) 9 January 2018 (2018-01-09) * figures 1-5 * | 1-19 | |
| A | ZHANG JIAN ET AL: "Design of Compact Bidirectional Amplifier Utilizing Transformers-Stacking Technique", IEEE TRANSACTIONS ON MICROWAVE THEORY AND TECHNIQUES IEEE, USA, vol. 73, no. 4, 11 December 2024 (2024-12-11), pages 1951-1963, XP034874112, ISSN: 0018-9480, DOI: 10.1109/TMTT.2024.3506735 [retrieved on 2024-12-11] * page 1951, left-hand column, line 32 - page 1960, right-hand column, line 23; figures 1-23 * | 1-19 | **TECHNICAL FIELDS SEARCHED (IPC)** H03F H04B |

The present search report has been drawn up for all claims

| Place of search | Date of completion of the search | Examiner |
|---|---|---|
| The Hague | 16 June 2026 | Fedi, Giulio |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P4C01)

## ANNEX TO THE EUROPEAN SEARCH REPORT
## ON EUROPEAN PATENT APPLICATION NO.

EP 26 15 5121

16-06-2026

| Patent document cited in search report | Publication date | Patent family member(s) | | Publication date |
|---|---|---|---|---|
| US 2021126590 A1 | 29-04-2021 | US | 2021126590 A1 | 29-04-2021 |
| | | WO | 2019183194 A1 | 26-09-2019 |
| CN 107566009 A | 09-01-2018 | NONE | | |

EPO FORM P0459

**REFERENCES CITED IN THE DESCRIPTION**

**Patent documents cited in the description**

- US 63752469